# EUROPÄISCHE PATENTSCHRIFT

(11) **EP 1 436 849 B1**
(45) Veröffentlichungstag und Bekanntmachung des Hinweises auf die Patenterteilung: **06.12.2006**
(21) Anmeldenummer: 02776820.9
(22) Anmeldetag: 15.10.2002
(51) Int. Cl.: H01L 43/06

(54) **KOMPAKTER VERTIKALER HALL-SENSOR**
COMPACT VERTICAL HALL SENSOR
CAPTEUR VERTICAL A EFFET HALL DE TYPE COMPACT

(30) Priorität: 16.10.2001 DE 10150950
(43) Veröffentlichungstag der Anmeldung: 14.07.2004
(73) Patentinhaber: FRAUNHOFER-GESELLSCHAFT ZUR FÖRDERUNG DER ANGEWANDTEN FORSCHUNG E.V., 80686 München (DE)
(72) Erfinder: HACKNER, Michael, 92331 Parsberg (DE); ERNST, Roland, 91052 Erlangen (DE); HOHE, Hans-Peter, 91332 Heiligenstadt (DE)
(74) Vertreter: Gagel, Roland
(86) Internationale Anmeldenummer: PCT/DE2002/003902
(87) Internationale Veröffentlichungsnummer: WO 2003/036732

(56) Entgegenhaltungen:
- EP-A- 0 244 577
- WO-A-01/18556
- SCHURIG E ET AL: "CMOS integrated vertical Hall sensor with low offset" EUROSENSORS XVI, 16TH EUROPEAN CONFERENCE ON SOLID-STATE TRANSDUCERS, PRAGUE, CZECH REPUBLIC, 15. - 18. September 2002, Seiten 868-871, XP002241233
- ERNST R ET AL: "Realising highly symmetric vertical Hall sensor elements on a standard CMOS process" EUROSENSORS XVI, 16TH EUROPEAN CONFERENCE ON SOLID-STATE TRANSDUCERS, PRAGUE, CZECH REPUBLIC, 15. - 18. September 2002, Seiten 329-330, XP009016535

## Beschreibung

### Technisches Anwendungsgebiet

Die vorliegende Erfindung betrifft einen vertikalen Hall-Sensor, bei dem sich ein erstes elektrisch leitfähiges Gebiet zur Bildung eines ersten Hall-Sensorelementes senkrecht zu einer Oberfläche eines Substrates in das Substrat erstreckt und erste Anschlussbereiche entlang einer an der Oberfläche liegenden Seitenfläche aufweist.

In vielen technischen Bereichen ist es erforderlich, die Stellung von Schaltern oder Stellgliedern berührungslos und damit verschleißfrei zu erfassen. Der Einsatz und die räumliche Erfassung von Magnetfeldern bietet in diesem Bereich Vorteile gegenüber einer optischen Erfassung, da auf Magnetfeldern basierende Techniken im Gegensatz zu optischen Verfahren wesentlich unempfindlicher gegenüber Verschmutzungen sind.

Für die räumliche Erfassung von Magnetfeldern werden Magnetfeld-Sensoren wie bspw. Hall-Sensoren eingesetzt. Derartige Sensoren lassen sich selbstverständlich für andere Anwendungsbereiche, bspw. in einem elektronischen Kompass ohne mechanische Komponenten, verwenden.

### Stand der Technik

Integrierte Magnetfeld-Sensoren auf Halbleiter-Basis, die den Hall-Effekt nutzen, sind in der Literatur und der Sensor-Industrie hinreichend bekannt. Ein Hall-Sensor besteht in der Regel aus einem elektrisch leitfähigen, plattenförmigen Gebiet, das über vier Kontaktelektroden mit einer externen Ansteuerschaltung verbunden ist. Von den vier Kontaktelektroden eines Hall-Sensors werden zwei als Steuerstrom-Kontaktelektroden zur Erzeugung eines Stromflusses durch das elektrisch leitfähige Gebiet und zwei als Mess-Kontaktelektroden zur Erfassung der Hall-Spannung genutzt, die bei einem anliegenden Magnetfeld senkrecht zur Richtung des Stromflusses in dem elektrisch leitfähigen Gebiet entsteht.

Bei in CMOS-Technik realisierten Hall-Sensoren besteht das elektrisch leitfähige Gebiet in der Regel aus einem n-dotierten aktiven Halbleiterbereich auf bzw. in einem p-dotierten Halbleitersubstrat.

Neben lateralen Hall-Sensoren, bei denen sich der elektrisch leitfähige Bereich parallel zur Oberfläche eines Halbleitersubstrates erstreckt und die sich zur Messung von Magnetfeldkomponenten senkrecht zu dieser Oberfläche eignen, werden zur räumlichen Erfassung eines Magnetfeldes auch Sensoren benötigt, die für Feld-Komponenten in den Raumrichtungen parallel zur Substrat-Oberfläche empfindlich sind.

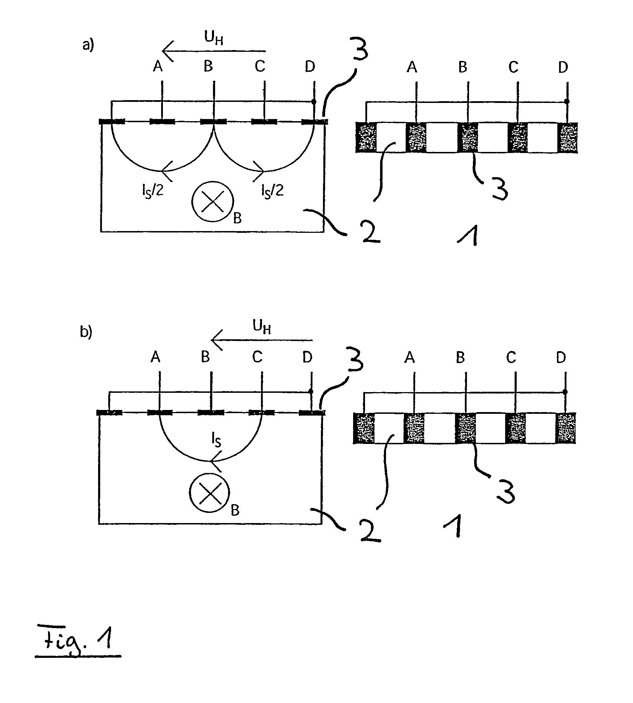

Für die Realisierung dieser so genannten vertikalen Hall-Sensoren sind Lösungen bekannt, die den Einsatz von Standard-Halbleitertechnologien zu deren Herstellung ermöglichen. Ein Beispiel ist der von Popovic und Baltes vorgeschlagene vertikale Hall-Sensor, wie er bspw. aus dem Buch "Rotary Switch and Current Monitor by Hall-Based Microsystems" der Autoren Ralph Steiner Vanha, Verlag: Physical Electronics Laboratory, Swiss Federal Institute of Technology (ETH) Zürich, 1999, Seiten 39 - 46, bekannt ist. Bei diesem vertikalen Hall-Sensor, der durch konforme Abbildung aus bekannten Geometrien lateraler Hall-Sensoren erhalten wird, erstreckt sich ein elektrisch leitfähiges Gebiet annähernd senkrecht zur Oberfläche eines Substrates in dieses hinein, wobei sämtliche Anschlussbereiche entlang einer Seitenfläche des elektrisch leitfähigen Gebietes an der Oberfläche des Substrates liegen. Figur 1 zeigt schematisch den Aufbau dieses vertikalen Hall-Sensors.

Diese aus dem Stand der Technik bekannten vertikalen Hall-Sensoren besitzen 5 entlang der Seitenfläche des elektrisch leitfähigen Gebietes in einer Reihe angeordnete Anschlussbereiche, von denen die beiden äußeren durch eine Verbindung außerhalb des Elementes zu einem gemeinsamen Anschluss zusammengefasst sind. Auf diese Weise werden wieder vier Anschlüsse wie beim lateralen Hall-Sensor erhalten. Die von Popovic und Baltes vorgeschlagene Ausgestaltung dieses vertikalen Hall-Sensors lässt es jedoch zu, das Element senkrecht zur Chip-Oberfläche zu integrieren und alle Anschlüsse an der Oberfläche zu kontaktieren. Auf der anderen Seite führt die vorgeschlagene Ausgestaltung jedoch zu langgestreckten Strukturen, die in Längsrichtung viel Platz auf dem Chip beanspruchen.

In bestimmten Anwendungsfällen ist jedoch der Raum, der für die Sensoren zur Verfügung steht, stark eingeschränkt. Eine beliebige Verkleinerung der Dimensionen, insbesondere der Länge des elektrisch leitfähigen Gebietes, der Abstände der Anschlussbereiche, usw., ist technologisch bedingt nicht möglich.

Ausgehend von diesem Stand der Technik besteht daher die Aufgabe der vorliegenden Erfindung darin, einen vertikalen Hall-Sensor anzugeben, der sich in kompakter Bauweise realisieren lässt.

### Darstellung der Erfindung

Die Aufgabe wird mit dem vertikalen Hall-Sensor gemäß Patentanspruch 1 gelöst. Vorteilhafte Ausgestaltungen dieses Hall-Sensors sind Gegenstand der Unteransprüche.

Bei dem vorgeschlagenen vertikalen Hall-Sensor erstreckt sich ein erstes elektrisch leitfähiges Gebiet zur Bildung eines ersten Hall-Sensorelementes senkrecht zu einer Oberfläche eines Substrates in das Substrat und weist erste Anschlussbereiche entlang einer an der Oberfläche des Substrates liegenden Seitenfläche auf. Parallel zum ersten Hall-Sensorelement ist ein zweites gleichartiges Hall-Sensorelement aus einem zweiten elektrisch leitfähigen Gebiet mit zweiten Anschlussbereichen im Substrat angeordnet, wobei ein an einem Ende des ersten elektrisch leitfähigen Gebietes liegender erster Anschlussbereich mit einem am diagonal gegenüber liegenden Ende des zweiten elektrisch leitfähigen Gebietes liegenden zweiten Anschlussbereich elektrisch verbunden ist.

Ein derartiger vertikaler Hall-Sensor weist die gleiche Funktion auf, wie ein aus einem einzigen elektrisch leitfähigen Gebiet bestehender Hall-Sensor mit einer um 1 oder 2 geringeren Anzahl von Anschlussbereichen. Durch die vorliegende Aufteilung des elektrisch leitfähigen Gebietes eines derartigen bekannten vertikalen Hall-Sensors in zwei parallel zueinander liegende kürzere elektrisch leitfähige Gebiete mit der entsprechenden Verschaltung lässt sich eine deutlich kompaktere Form des Hall-Sensors realisieren. Diese kompaktere Bauweise bietet insbesondere dann Vorteile, wenn der für die Länge der bekannten vertikalen Hall-Sensoren verfügbare Raum auf dem Substrat bzw. Chip beschränkt ist.

Auch wenn im Folgenden die bevorzugte Ausführungsform des vorliegenden Hall-Sensors ausgehend von einem vertikalen Hall-Sensor des Standes der Technik mit fünf Anschlussbereichen und vier Anschlüssen beschrieben wird, so lässt sich der vorliegende Hall-Sensor auch mit einer größeren Anzahl von Anschlussbereichen bzw. Anschlüssen realisieren, wobei der vorgeschlagene vertikale Hall-Sensor gegenüber einem herkömmlichen vertikalen Hall-Sensor mit einer ungeraden Anzahl von n Anschlussbereichen und n-1 Anschlüssen jeweils einen Anschlussbereich mehr aufweist, um die gleiche Funktion zu erfüllen. Ausgehend von einem vertikalen Hall-Sensor mit einer geraden Anzahl von n Anschlussbereichen weist der vorgeschlagene Hall-Sensor für die gleiche Funktion jeweils zwei Anschlussbereiche mehr auf, die die äußeren diagonal miteinander verbundenen Anschlussbereiche bilden. Der vorgeschlagene Hall-Sensor hat somit immer eine gerade Anzahl von Anschlussbereichen.

Grunsätzlich lässt sich der vorliegende Hall-Sensor hierbei gedanklich aus einem Hall-Sensor des Standes der Technik dadurch bilden, dass das elektrisch leitfähige Gebiet in der Mitte aufgetrennt und die beiden Hälften gegeneinander verschoben und parallel zueinander angeordnet werden. Die Verschaltung der einzelnen bereits vorhandenen Anschlussbereiche wird dabei nicht geändert. Bei einem bekannten Sensor mit einer ungeraden Anzahl von Anschlussbereichen wird dabei der mittlere Anschlussbereich in zwei Anschlussbereiche aufgespalten, die nach der parallelen Anordung an diagonal gegenüber liegenden Enden der beiden neu gebildeten elektrisch leitfähigen Bereiche liegen und elektrisch miteinander verbunden werden müssen. Bei einem bekannten Sensor mit einer geraden Anzahl von Anschlussbereichen wird auf beiden Seiten der Auftrennung jeweils ein neuer Anschlussbereich geschaffen, wobei die beiden neuen Anschlussbereiche nach der parallelen Anordung an diagonal gegenüber liegenden Enden der beiden neu gebildeten elektrisch leitfähigen Bereiche liegen und ebenfalls elektrisch miteinander verbunden werden müssen.

Vorzugsweise weist der vorliegende vertikale Hall-Sensor an jedem der beiden elektrisch leitfähigen Gebiete, die beispielsweise als Halbleiter-Schichten in einem Halbleitersubstrat realisiert sind, jeweils drei Anschlussbereiche auf, im Folgenden auch als Kontakte bezeichnet. Diese Anschlussbereiche oder Kontakte sind an den beiden elektrisch leitfähigen Gebieten bzw. Schichten in einer Reihe angeordnet. Hierbei ist jedoch nicht zwingend notwendig, dass die drei Anschlussbereiche jeweils exakt auf einer geraden Linie liegen. Selbstverständlich können sie von dieser Linie auch auf beiden Seiten abweichen. Die beiden äußeren Kontakte des ersten und des zweiten elektrisch leitfähigen Gebietes sind über Kreuz miteinander verbunden. Dadurch entsteht ein Hall-Sensor mit insgesamt vier Anschlüssen, die wie bei einem herkömmlichen Hall-Sensor geschaltet werden können, um die entsprechende Hall-Spannung bei Anliegen eines magnetischen Feldes abgreifen zu können. Auch der Betrieb mittels einer Spinning-Current-Technik ist bei diesem Hall-Sensor, der auf magnetische Felder parallel zur Substrat-oberfläche empfindlich ist, selbstverständlich möglich.

Die Spinning-Current-Technik besteht darin, die Messrichtung am Hall-Sensor ständig mit einer bestimmten Taktfrequenz um bspw. 90° zyklisch weiter zu drehen und über alle Messsignale einer vollen Drehung um 360° zu summieren. Bei einem Hall-Sensor mit vier Kontakten, von denen sich jeweils zwei gegenüber liegen, wird daher jeder der Kontakte je nach Spinning-Current-Phase sowohl als Steuerstrom-Kontakt als auch als Mess-Kontakt zur Abnahme des Hall-Signals genutzt. So fließt in einer Phase bzw. einem Zyklus der Steuerstrom von einem zum gegenüber liegenden Kontakt, wobei die Hall-Spannung an den quer dazu liegenden Kontakten abgegriffen wird. Beim nächsten Zyklus wird dann die Messrichtung um 90° weiter gedreht, so dass die Kontakte, die im vorangehenden Zyklus zur Abnahme der Hall-Spannung eingesetzt wurden, nunmehr zur Einspeisung des Steuerstroms dienen. Durch die Summation über alle vier Zyklen bzw. Phasen heben sich herstellungs- oder materialbedingte Offset-Spannungen annähernd gegenseitig auf, so dass nur die tatsächlich magnetfeldabhängigen Anteile des Signals übrig bleiben.

Die äußere Ansteuerbarkeit bzw. Beschaltung des vorliegenden vertikalen Hall-Sensors entspricht der eines bekannten Hall-Sensors des Standes der Technik mit fünf entlang der Seitenfläche eines elektrisch leitfähigen Gebietes an der Oberfläche eines Substrates liegenden Kontakten. Gegenüber diesem bekannten vertikalen Hall-Sensor ist der vorliegende Hall-Sensor etwa um 40 % kürzer. Allerdings wird durch die vorliegende Ausgestaltung auch eine etwas ungünstigere Steuerstromverteilung und somit ein größerer Offset erzeugt. In der bevorzugten Ausgestaltung eignet sich der vorliegende Hall-Sensor daher gerade in Anwendungen mit geringeren Anforderungen an die elektrischen und magnetischen Kenngrößen des Sensors, um zumindest in einer Dimension Bauraum auf dem IC einsparen zu können.

Selbstverständlich lässt sich die gegenüber dem bekannten Hall-Sensor ungünstigere Steuerstromverteilung auch durch entsprechende Gewichtung der einzelnen Spinning-Current-Phasen bei einem Spinning-Current-Betrieb ausgleichen. Weiterhin ist es möglich, zumindest zwei der vorliegenden vertikalen Hall-Sensoren derart miteinander zu verschalten, dass diese wie ein einziger Hall-Sensor angesteuert werden und in jeder Spinning-Current-Phase jeweils die gleiche Kombination von Steuerstromverteilungen aufweisen. Durch eine derartige Verschaltung lässt sich der Offset deutlich verringern und macht eine zusätzliche Gewichtung der einzelnen Spinning-Current-Phasen überflüssig.

Der vorliegende vertikale Hall-Sensor ist vorzugsweise in CMOS-Technik realisiert, wobei die elektrisch leitfähigen Gebiete als n-dotierte Halbleiterbereiche in einem p-dotierten Substrat vorliegen können.

### Kurze Beschreibung der Zeichnungen

Der vorgeschlagene vertikale Hall-Sensor wird nachfolgend anhand eines Ausführungsbeispiels in Verbindung mit den Zeichnungen nochmals kurz erläutert. Hierbei zeigen:
- Fig. 1: ein Beispiel für einen vertikalen Hall-Sensor des Standes der Technik sowie der zugehörigen Steuerstromverteilungen in zwei Spinning-Current-Phasen;
- Fig. 2: ein Beispiel für die Ausgestaltung des vorliegenden vertikalen Hall-Sensors in Draufsicht im Vergleich zu einem bekannten vertikalen Hall-Sensor; und
- Fig. 3: die Steuerstromverteilung in dem vorliegenden vertikalen Hall-Sensor der Figur 2 in verschiedenen Spinning-Current-Phasen.

### Wege zur Ausführung der Erfindung

Figur 1 zeigt ein Beispiel für den Aufbau eines bekannten vertikalen Hall-Sensors, wie er von Popovic und Baltes vorgeschlagen wurde. In Figur 1a ist hierbei im linken Teil eine Seitenansicht des Hall-Sensors parallel zur Oberfläche des Halbleiter-Chips, in dem der Sensor integriert ist, dargestellt. Die Figur zeigt das elektrisch leitfähige Gebiet 2, das sich senkrecht zur Oberfläche des Chips 1 in diesen Chip erstreckt. Das elektrisch leitfähige Gebiet 2 ist plattenförmig ausgebildet, so dass seine Länge und Tiefe, die im linken Teil der Figur 1a zu erkennen sind, deutlich größer als seine im rechten Teil der Figur erkennbare Breite sind. Dies entspricht der typischen Ausgestaltung des elektrisch leitfähigen Gebietes eines Hall-Sensorelementes. Selbstverständlich kann die Breite des elektrisch leitfähigen Gebietes eines Hall-Sensors für dessen Funktion auch größer als die Länge und Tiefe ausfallen.

In der Figur sind weiterhin die elektrischen Anschlussbereiche 3 entlang der Seitenfläche des elektrisch leitfähigen Gebietes 2 an der Oberfläche des Chips 1 zu erkennen. Die beiden äußeren Anschlussbereiche sind elektrisch leitend miteinander verbunden und bilden einen gemeinsamen äußeren Anschluss D. Die weiteren Anschlussbereiche bilden entsprechend ihrer Reihenfolge die elektrischen Anschlüsse A, B und C. Der gesamte Hall-Sensor, der sich nur aus einem einzelnen Hall-Sensorelement zusammen setzt, ist im rechten Teil der Figur 1a nochmals in Draufsicht, d. h. senkrecht auf die Chip-Oberfläche, zu erkennen. In dieser Darstellung sind insbesondere die entlang der Seitenfläche des elektrisch leitfähigen Gebietes 2 ausgebildeten Anschlussbereiche 3 zu erkennen, die insgesamt zu den vier Anschlüssen A - D des Hall-Sensors zusammengefasst sind.

Beim Betrieb dieses bekannten vertikalen Hall-Sensors mit einer Spinning-Current-Technik wird in einer ersten Spinning-Current-Phase durch Anlegen einer Steuerspannung zwischen den Anschlüssen D und B ein Steuerstrom I_{S} erzeugt, der in dem elektrisch leitfähigen Gebiet 2 eine Steuerstromverteilung entsprechend der schematischen Darstellung der Figur 1a ergibt. Hierbei fließt jeweils ein Steuerstrom der Größe I_{S}/2 vom Anschluss B zu den beiden Anschlussbereichen des Anschlusses D. Bei Vorliegen eines magnetischen Feldes B parallel zur Chip-Oberfläche, wie dies ebenfalls in der Figur 1a schematisch dargestellt ist, entsteht eine Hall-Spannung U_{H} zwischen den Anschlüssen C und A, die mit dem Pfeil angedeutet ist. Durch Abgreifen der beiden Anschlüsse A und C kann die Hall-Spannung U_{H} gemessen und daraus die Größe des Magnetfeldes B berechnet werden.

In der nächsten Spinning-Current-Phase wird der Steuerstrom zwischen den beiden Anschlüssen A und C angelegt, wobei ein Steuerstrom I_{S} zwischen diesen beiden Anschlüssen durch das elektrisch leitfähige Gebiet 2 fließt, wie dies im linken Teil der Figur 1b angedeutet ist. Die Figur 1b zeigt die gleiche Anordnung in Seitenansicht (links) und Draufsicht (rechts) wie die Figur 1a, jedoch beim Betrieb mit einer anderen Spinning-Current-Phase. Die unterschiedliche Steuerstromverteilung im elektrisch leitfähigen Gebiet 2 in den beiden unterschiedlichen Spinning-Current-Phasen ist aus den Figuren 1a und 1b deutlich zu erkennen.

Die beiden verbleibenden Spinning-Current-Phasen ergeben sich analog aus den beiden ersten Phasen durch Umkehrung der Strom- und Spannungs-Richtungen.

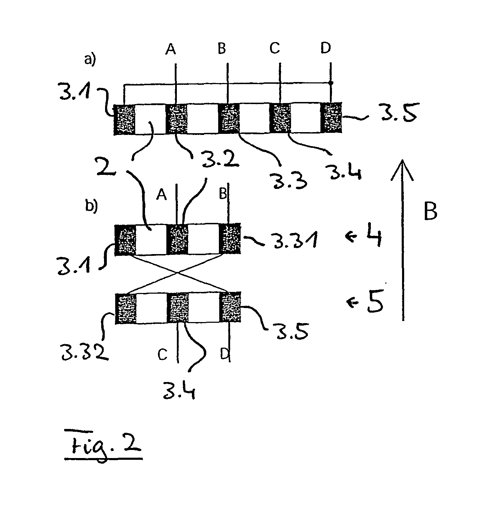

Figur 2 zeigt ein Ausführungsbeispiel für den vorliegenden vertikalen Hall-Sensor im Vergleich zu einem vertikalen Hall-Sensor mit der gleichen Anzahl von äußeren Anschlüssen A - D und der gleichen Funktion, wie er bereits in Verbindung mit Figur 1 erläutert wurde. Beide Hall-Sensoren sind hierbei in Draufsicht auf die Chipoberfläche zu erkennen.

Bei dem bekannten vertikalen Hall-Sensor des Standes der Technik (Fig. 2a) wird die Längserstreckung durch die Länge des elektrisch leitfähigen Gebietes 2 mit den fünf in Reihe angeordneten Anschlussbereichen 3.1 bis 3.5 vorgegeben, von denen die beiden äußeren 3.1 und 3.5 elektrisch leitend verbunden und zu einem einzelnen externen Kontakt D zusammengefügt sind. Die weiteren Anschlussbereiche 3.2 - 3.4 bilden jeweils getrennte Kontakte A - C. Der Betrieb eines derartigen Sensors wurde bereits im Zusammenhang mit der Figur 1 erläutert.

Figur 2b zeigt ein Beispiel für die Ausgestaltung eines vertikalen Hall-Sensors gemäß der vorliegenden Erfindung, der die gleiche Anzahl von externen Anschlüssen A - D aufweist und somit die gleichen Betriebsweisen und die gleiche Funktionsweise wie der Hall-Sensor der Figur 1a ermöglicht. Dieser neuartige vertikale Hall-Sensor wird aus dem Hall-Sensor des Standes der Technik (Figur 2a) dadurch abgeleitet, dass der elektrisch leitfähige Bereich 2 in der Mitte des Anschlussbereiches 3.3 aufgetrennt und die beiden entstandenen Hälften parallel zueinander plaziert werden. Durch kreuzweises Verbinden der dabei entstandenen äußeren Anschlussbereiche 3.1 und 3.5 bzw. 3.31 und 3.32 wird wieder ein magnetisch empfindlicher Sensor erhalten, der - wie der Sensor der Figur 2a - vier externe Anschlüsse A - D aufweist und wie ein herkömmlicher Hall-Sensor geschaltet und betrieben werden kann.

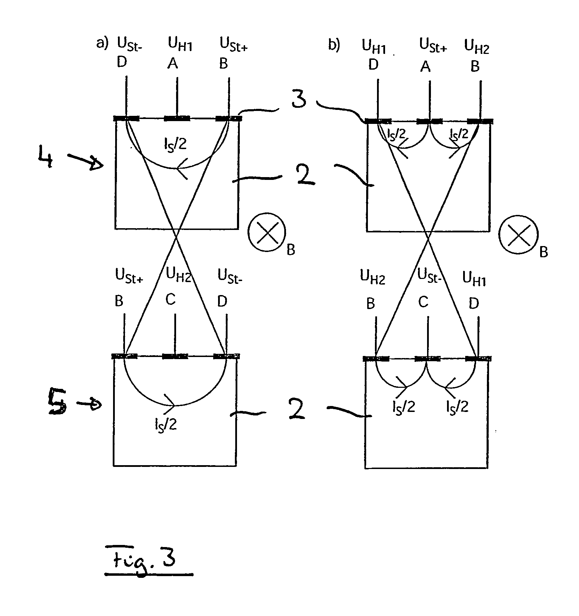

Figur 3 zeigt die Beschaltung und Stromverteilung in einem derartigen Hall-Sensor in zwei Betriebsphasen der Spinning-Current-Technik. Die beiden elektrisch leitfähigen Bereiche (2) sind hierbei zur besseren Darstellbarkeit übereinander in Seitenansicht eingezeichnet, liegen jedoch tatsächlich parallel nebeneinander im Substrat.

Figur 3a zeigt hierbei eine erste Phase, bei der die Steuerspannung zwischen den Anschlüssen B und D angelegt und die Hall-Spannung zwischen den Anschlüssen A und C abgegriffen wird. In dieser Phase ist die Verteilung des Steuerstroms identisch der eines herkömmlichen Hall-Elementes (vgl. Figur 1a), wobei der Steuerstrom von Anschluss B nach Anschluss D fließt.

Die Steuerstromverteilung unterscheidet sich jedoch in der nächsten Phase des Spinning-Current-Betriebs deutlich von der des herkömmlichen Elementes, wie in Figur 3b zu erkennen ist. Bei dieser Phase, bei der die Steuerspannung zwischen den Anschlüssen A und C des Hall-Sensors angelegt und die Hall-Spannung zwischen den Anschlüssen B und D abgegriffen wird, wird der Steuerstrom auf seinem Weg von A nach C über die Kontakte B und D gezwungen. Dies führt jedoch dazu, dass der Vorteil des kompakteren Elementes durch den Nachteil einer ungleichmäßigeren Stromverteilung erkauft wird. Diese ungleichmäßigere Stromverteilung zwischen den einzelnen Phasen im Vergleich zu dem bekannten vertikalen Hall-Element des Standes der Technik, kann jedoch durch andere Maßnahmen, wie bspw. eine Kalibrierung der Spinning-Current-Phasen zueinander oder durch Parallelschaltung mehrerer derartiger Hall-Sensoren kompensiert werden.

### Bezugszeichenliste

- 1: Substrat bzw. Chip
- 2: elektrisch leitfähiges Gebiet
- 3: Anschlussbereiche
- 3.1 - 3.5: einzelne Anschlussbereiche
- 4: erstes Hall-Sensorelement
- 5: zweites Hall-Sensorelement
- A - D: externe Anschlüsse

## Patentansprüche

1. Vertikaler Hall-Sensor, bei dem sich ein erstes elektrisch leitfähiges Gebiet (2) zur Bildung eines ersten Hall-Sensorelementes (4) senkrecht zu einer Oberfläche eines Substrates (1) in das Substrat (1) erstreckt und erste Anschlussbereiche (3) entlang einer an der Oberfläche des Substrates (1) liegenden Seitenfläche aufweist, und bei dem ein zweites gleichartiges Hall-Sensorelement (5) aus einem zweiten elektrisch leitfähigen Gebiet (2) parallel zum ersten Hall-Sensorelement (4) im Substrat (1) angeordnet ist,
**dadurch gekennzeichnet,**
**dass** zweite Anschlussbereiche (3) des zweiten elektrisch leitfähigen Gebiets (2) entlang der an der Oberfläche des Substrates (1) liegenden Seitenfläche vorgesehen sind und ein an einem Ende des ersten elektrisch leitfähigen Gebietes (2) liegender erster Anschlussbereich (3.31) mit einem am diagonal gegenüber liegenden Ende des zweiten elektrisch leitfähigen Gebietes (2) liegenden zweiten Anschlussbereich (3.32) elektrisch verbunden ist.

2. Vertikaler Hall-Sensor nach Anspruch 1,
**dadurch gekennzeichnet**,
das erste (4) und das zweite Hall-Sensorelement (5) jeweils drei erste bzw. zweite Anschlussbereiche (3) aufweisen.

3. Vertikaler Hall-Sensor nach Anspruch 1 oder 2,
**dadurch gekennzeichnet,**
**dass** zumindest zwei weitere gleichartige Hall-Sensor-Elemente mit identischer Verschaltung parallel zum ersten (4) und zweiten Hall-Sensorelement (5) im Substrat (1) angeordnet und derart mit dem ersten (4) und zweiten Hall-Sensorelement (5) elektrisch verbunden sind, dass sich beim Betrieb des Hall-Sensors mittels einer Spinning-Current-Technik in jeder Spinning-Current-Phase die gleiche Kombination von Steuerstromverteilungen im Hall-Sensor ergibt.

4. Vertikaler Hall-Sensor nach einem der Ansprüche 1 bis 3,
**dadurch gekennzeichnet,**
**dass** das Substrat (1) ein Halbleitersubstrat ist und das erste und zweite elektrisch leitfähige Gebiet durch dotierte Bereiche in dem Halbleitersusbtrat (1) gebildet sind.

## Claims

1. A vertical Hall sensor, in which a first electrically conductive area (2) extends perpendicular to a surface of a substrate (1) into the substrate (1) to form a first Hall sensor element (4) and has first terminal areas (3) along a lateral face lying on the surface of the substrate (1), and in which a second identical Hall sensor element (5) made of a second electrically conductive area (2), is situated parallel to the first Hall sensor element (4) in the substrate (1),
**characterized in that** second terminal areas (3) of the second electrically conductive area (2) are provided along a lateral face lying at the surface of the substrate (1) and a first terminal area (3.31) lying at one end of the first electrically conductive area (2) is electrically connected to a second terminal area (3.32) lying at the diagonally opposite end of the second electrically conductive area (2).

2. The vertical Hall sensor according to Claim 1,
**characterized in that** the first (4) and the second Hall sensor element (5) each have three first or second terminal areas (3), respectively.

3. The vertical Hall sensor according to Claim 1 or 2,
**characterized in that** at least two further identical Hall sensor elements having identical interconnection are situated parallel to the first (4) and second Hall sensor elements (5) in the substrate (1) and are electrically connected to the first (4) and second Hall sensor elements (5) in such a way that, during operation of the Hall sensor using a spinning current technology, the identical combination of control current distributions in the Hall sensor results in every spinning current phase.

4. The vertical Hall sensor according to one of Claims 1 through 3,
**characterized in that** the substrate (1) is a semiconductor substrate and the first and second electrically conductive areas are formed by doped areas in the semiconductor substrate (1).

## Revendications

1. Capteur Hall vertical, sur lequel une première zone conductible (2) formant un premier élément (4) du capteur Hall s'étend perpendiculairement à une surface de substrat (1) dans le substrat (1) et comporte des premières zones de raccordement (3) le long d'une face latérale à la surface du substrat (1), et sur lequel un deuxième élément de capteur Hall du même type (5) constitué d'une deuxième zone conductible (2) est placé de façon parallèle par rapport au premier élément de capteur Hall (4) dans le substrat (1),
**caractérisé en ce que**
une deuxième série de zones de raccordement (3) de la deuxième zone conductible (2) est prévue le long de la face latérale à la surface du substrat (1) et **en ce qu'**à une extrémité de la première zone conductible (2) se trouve une première zone de raccordement (3.31) reliée électriquement à une deuxième zone de raccordement (3.32) située à l'extrémité diagonalement opposée sur la deuxième zone conductible (2).

2. Capteur Hall vertical selon la revendication 1,
**caractérisé en ce que**
le premier (4) et le deuxième élément du capteur Hall (5) comportent chacun trois premières zones de raccordement (3) ou trois deuxièmes zones de raccordement.

3. Capteur Hall vertical selon la revendication 1 ou 2,
**caractérisé en ce que**
au moins deux autres éléments de capteur Hall du même type avec une mise en circuit identique sont placés de façon parallèle au premier (4) et au deuxième élément du capteur Hall (5) dans le substrat (1) et sont reliés de telle façon avec le premier et le deuxième éléments de capteur Hall (5), que lors du fonctionnement du capteur Hall au moyen d'une technique de Spinning Current, on retrouve dans chacune des phases de Spinning Current la même combinaison de répartitions du courant de commande dans le capteur Hall.

4. capteur Hall vertical selon l'une des revendications 1 à 3,
**caractérisé en ce que**
le substrat (1) est un substrat semi-conducteur, et **en ce que** la première et la deuxième zone conductible sont formées par des zones dopées dans le substrat semi-conducteur (1).
